# EUROPEAN PATENT APPLICATION

(11) **EP 3 128 537 A1**
(43) Date of publication of application: **08.02.2017**
(21) Application number: 14888376.2
(22) Date of filing: 31.03.2014
(51) Int. Cl.: H01L 21/3065, B01J 3/02, H01L 21/205

(54) **PLASMA PROCESSING DEVICE AND OPENING/CLOSING MECHANISM USED THEREIN**

(71) Applicant: SPP Technologies Co., Ltd., Tokyo 100-0004 (JP)
(72) Inventor: HAYAMI, Toshihiro, Amagasaki-shi Hyogo 660-0891 (JP)
(74) Representative: Isarpatent
(86) International application number: PCT/JP2014/059431
(87) International publication number: WO 2015/151149

(57) **Abstract**

A plasma etching apparatus 1 includes a processing chamber 2 having a plasma generating portion 3, a processing portion 4, an exhaust portion 5, and a manifold portion 6 defined inside, and an exhaust mechanism 30 for exhausting gas in the processing chamber 2, the exhaust mechanism 30 is composed of a vacuum pump 31 having an intake port connected to an opening 8, a valve body 32 inserted through an opening 9, and a moving mechanism 34 for moving the valve body 32 in upward and downward directions, and the intake port of the vacuum pump 31 is connected to the opening 8 which is formed in a third chamber 2c forming a part of the processing chamber 2.

## Description

### Technical Field

0001 The present invention relates to a plasma processing apparatus that supplies a predetermined processing gas into an evacuated processing chamber, generates plasma from the processing gas, and performs a plasma processing on a substrate in the processing chamber by the plasma generated from the processing gas and to an opening and closing mechanism used in the plasma processing apparatus, and particularly relates to a plasma processing apparatus that is capable of efficiently evacuating a processing chamber and to an opening and closing mechanism used in the plasma processing apparatus.

### Background Art

0002 Examples of the above-mentioned plasma processing include a plasma etching processing in which a substrate (a silicon substrate, a silicon carbide substrate, or the like) is etched by ions and radicals contained in plasma generated from a processing gas, and a plasma CVD processing in which a thin film is formed on a substrate.

0003 A plasma processing apparatus used for performing the plasma processing typically includes a processing chamber having a processing portion, a plasma generating portion, an exhaust portion and a manifold portion defined in its inner space, a coil disposed outside a portion of the processing chamber where the plasma generating portion is defined, a platen disposed in the processing portion, a coil power supply mechanism for supplying RF power to the coil, a processing gas supply mechanism for supplying a processing gas, e.g., an etching gas or a passivation-film forming gas, into the plasma generating portion, an exhaust mechanism for exhausting gas in the processing chamber, and other components. In the processing chamber, the plasma generating portion is defined in an upper region, the processing portion, which communicates with the plasma generating portion, is defined below the plasma generating portion, the exhaust portion, which communicates with the processing portion, is defined below the processing portion, and the manifold portion, which communicates with the exhaust portion, is defined at a position adjacent to the exhaust portion.

0004 When a plasma process is performed using such a plasma processing apparatus, a processing gas is supplied into the plasma generating portion, and the inside of the processing chamber is kept in a vacuum state by exhausting gas in the processing chamber while adjusting the exhaust velocity by the exhaust mechanism.

0005 Note that the exhaust mechanism of the plasma processing apparatus is typically composed of a vacuum valve for adjusting the pressure in the processing chamber and a vacuum pump (a turbomolecular pump, a cryo pump, an oil diffusion pump, or the like) connected to a portion of the processing chamber corresponding to the manifold portion through piping or the like.

0006 An example of a vacuum valve used in such an exhaust mechanism is a vacuum valve disclosed in Japanese Patent No. 5243201.

0007 This vacuum valve includes a body having a valve chest formed inside and two ports formed therein which perpendicularly communicate with each other through the vacuum chest and having a valve seat formed at an opening edge of one of the two ports, a valve body provided in the valve chest to be movable forward and backward with respect to the valve seat, and a drive unit applying a driving force to the valve body. One of the ports is connected to the manifold portion and the other is connected to an intake port of the vacuum pump.

0008 According to this vacuum valve, a flow path between the two ports, that is, a flow path between the processing chamber and the vacuum pump is opened or closed by separating the valve body from the valve seat or bringing the valve body into contact with the valve seat by the drive unit, which adjusts the exhaust velocity.

### Citation List

### Patent Literature

0009 *Patent document 1:* Japanese Patent No. 5243201

### Summary of Invention

### Technical Problem

0010 By the way, when gas in the processing chamber is exhausted using the above-described vacuum valve, gas molecules which freely move at an average speed collide with each other much more frequently than with an inner wall of the processing chamber or an inner wall of the body (hereinafter, simply referred to as "the wall") and the mean free path of gas molecules is short (hereinafter, this state is referred to as "the viscous flow region") until the processing chamber reaches a low vacuum state after start of the exhaust of gas, while gas molecules collide with the wall more frequently than with each other and the mean free path of gas molecules is long (hereinafter, this state is referred to as "the molecular flow region") after the exhaust of gas has been advanced and the processing chamber has reached a medium vacuum state or a high vacuum state.

0011 In the molecular flow region, the gas molecules having a long mean free path reach the intake port of the vacuum pump with a certain probability and the gas molecules are discharged from the processing chamber, by which the processing chamber is evacuated. Therefore, the evacuation efficiency is higher when the probability that gas molecules reach the vacuum pump is higher; the evacuation efficiency is lower when the probability is lower.

0012 Accordingly, in a plasma processing apparatus including the above-described vacuum valve, the problem as described below occurs especially when the pressure in the processing chamber is reduced to a high vacuum state.

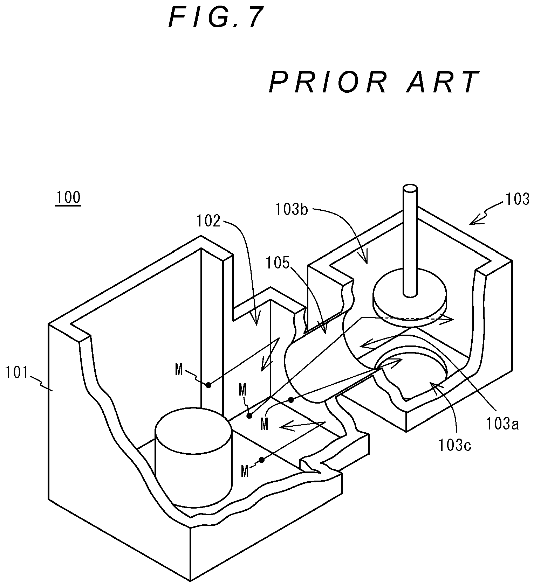

0013 That is, as shown in Fig. 7, a plasma processing apparatus 100 including the above-described conventional vacuum valve has a structure in which a vacuum pump is connected to a manifold portion 102 of a processing chamber 101 through a vacuum valve 103; therefore, the distance that gas molecules M have to move before reaching a vacuum pump 104 is long. In order to reach an intake port of the vacuum pump, gas molecules M in the manifold portion 102 have to reach the inside of a valve chest 103b from the manifold portion 102 through one port 103a first, and further have to reach the intake port of the vacuum pump from the inside of the valve chest 103b through the other port 103c. Therefore, the probability that gas molecules M reach the vacuum pump is greatly reduced and the number of gas molecules M reaching the vacuum pump is reduced, which greatly deteriorates the evacuation efficiency.

0014 Further, the two ports 103a and 103c perpendicularly communicate with each other through the valve chest 103b, that is, the flow path from the manifold portion 102 to the intake port of the vacuum pump is curved or bent, and further the manifold portion 102 and the valve chest 103b are connected to each other through a flange portion 105 and therefore the probability that gas molecules M reach the inside of the flange portion 105 from the manifold portion 12 is low. These are also factors that greatly reduce the probability that gas molecules M reach the vacuum pump from the manifold portion 102.

0015 Additionally, besides the above-described vacuum valve, a pendulum type valve may be used as a mechanism for adjusting the pressure in the processing chamber and this makes it possible to shorten the distance between the manifold portion and the vacuum pump; however, a pendulum type valve fails to provide a sufficient effect when it is applied to a small-sized plasma processing apparatus for performing a plasma processing on a small-diameter substrate (for example, a substrate having a diameter equal to or smaller than 1 inch). That is, if a pendulum type valve is used in a small-sized plasma processing apparatus, a problem occurs that the probability that gas molecules reach the vacuum pump is greatly reduced because the size of the pendulum type valve is relatively large with respect to the size of the entire plasma processing apparatus and the distance between the manifold portion and the vacuum pump is long.

0016 The present invention has been achieved in view of the above-described circumstances, and an object thereof is to provide a plasma processing apparatus that is capable of efficiently reducing the pressure in a processing chamber to high vacuum and is capable of controlling the pressure in the processing chamber in a high vacuum state, and an opening and closing mechanism used in the plasma etching apparatus.

### Solution to Problem

0017 The present invention, for solving the above-described problems, relates to a plasma processing apparatus that generates plasma from a processing gas supplied into a processing portion defined in a processing chamber and performs a plasma processing on a substrate placed on a platen disposed in the processing portion by the plasma generated from the processing gas,
the processing chamber having an exhaust portion defined below the processing portion and a manifold portion defined adjacent to the exhaust portion, and having an opening formed in a portion thereof corresponding to the manifold portion, the exhaust portion being a space communicating with the processing portion, the manifold portion being a space communicating with the exhaust portion,
the manifold portion having a flow-path effective cross-sectional area larger than the opening,
the plasma processing apparatus further including:
a vacuum pump having an intake port connected to the opening; and
an opening and closing mechanism for opening and closing the opening,
the opening and closing mechanism being composed of:
a valve body disposed in the manifold portion at a position facing the opening to be movable in approaching and separating directions with respect to the opening; and
a moving mechanism for moving the valve body in the approaching and separating directions.

0018 According to this plasma processing apparatus, first, a substrate is placed on the platen. Subsequently, exhaust of gas in the processing chamber is started by operating the vacuum pump with the valve body separated from the opening.

0019 Note that, in the plasma processing apparatus of the present invention, the distance from the manifold portion to the vacuum pump is made as short as possible by connecting the opening formed in a portion of the processing chamber corresponding to the manifold portion to the intake port of the vacuum pump and the manifold portion has a flow-path effective cross-sectional area larger than the area of the opening. Thereby, even when the processing chamber has reached a high vacuum state (the molecular flow region) and the probability that gas molecules reach the vacuum pump affects the evacuation efficiency, the probability that gas molecules reach the vacuum pump is high and gas molecules easily reach the vacuum pump; therefore, the processing chamber can be evacuated with less deterioration of the evacuation efficiency.

0020 Further, unlike the conventional vacuum valve, the flow path from the manifold portion to the intake port of the vacuum pump has no curved or bent portion since the intake port of the vacuum pump is connected to the opening, which prevents the problem that the probability that gas molecules reach the vacuum pump is reduced.

0021 Further, although the conventional art requires a connecting member, e.g., a flange joint or the like, for connecting the vacuum valve to the manifold portion, the above-described plasma processing apparatus does not require a connecting member, and therefore the distance from the manifold portion to the intake port of the vacuum pump is correspondingly short. Therefore, the probability that gas molecules reach the vacuum pump is increased and it is possible to create a small-sized plasma processing apparatus that performs a plasma processing on a substrate having a diameter equal to or smaller than 1 inch.

0022 Further, the above-described plasma processing apparatus has the valve body provided in the manifold portion, and this also makes it possible to create a small-sized plasma processing apparatus.

0023 Subsequently, a processing gas is supplied into the processing portion and plasma is generated from the processing gas, and a plasma processing is performed on the substrate placed on the platen by the plasma generated from the processing gas.

0024 Note that, while the plasma processing is being performed on the substrate, the size of the space between the valve body and the opening is changed by adjusting the position of the valve body in the approaching and separating directions by the moving mechanism, and thereby the probability that gas molecules reach the intake port of the vacuum pump from the manifold portion is adjusted so as to keep the pressure in the processing chamber at a certain level.

0025 Further, it is preferred that the opening in the plasma processing apparatus has an edge formed to be spaced from an inner wall of a portion of the processing chamber where the manifold portion is defined. This configuration makes it possible to enlarge the solid angle as viewed from the opening and thereby further increase the probability that gas molecules reach the intake port of the vacuum pump from the manifold portion. Note that the space between the edge of the opening and the inner wall of the processing chamber is preferably equal to or greater than 20 % of the diameter of the opening, more preferably equal to or greater than 25 % of the diameter of the opening, so that the probability that gas molecules reach the intake port of the vacuum pump can be sufficiently increased.

0026 Further, in the above-described plasma processing apparatus, the intake port of the vacuum pump may be directly connected to the opening. That is, the intake port of the vacuum pump and the opening may be connected to each other with no other connecting member between them. Specifically, the apparatus may have a configuration in which a flange joint is formed only on the vacuum pump without forming a flange joint on a portion of the processing chamber corresponding to the manifold portion and the intake port of the vacuum pump is connected to the opening by screwing the flange joint to a portion corresponding to the manifold portion. This configuration makes it possible to further shorten the distance from the manifold potion to the vacuum pump; therefore, it is possible to further increase the probability that gas molecules reach the vacuum pump, and it is possible to make the apparatus more compact.

0027 Furthermore, for the purpose of improvement of maintainability, it is preferred that the opening and closing mechanism of the plasma processing apparatus can be attached to and detached from the processing chamber along the approaching and separating directions.

0028 Note that the term "flow-path effective cross-sectional area" as used in the application means the area of a cross section obtained by cutting the flow path along a plane perpendicular to the flow direction; in the case where the cross-sectional area varies along the flow direction, the term means the smallest one.

0029 Further, the term "vacuum pump" as used in the application means a vacuum pump which is directed to high vacuum pumping and examples of the vacuum pump include a turbomolecular pump, a cryo pump, and an oil diffusion pump.

0030 Further, as for the "substrate" in the application, examples thereof include substrates made of silicon, silicon carbide, sapphire, compound semiconductor, glass, and resin.

### Advantageous Effects of Invention

0031 As described above, according to the plasma processing apparatus of the present invention, it is possible to efficiently reduce the pressure in the processing chamber to high vacuum and control the pressure in the processing chamber in a high vacuum state, and it is possible to make the apparatus compact.

### Brief Description of Drawings

0032
Fig. 1 is a front sectional view showing a schematic configuration of a plasma etching apparatus according to an embodiment of the present invention,
Fig. 2 is a sectional view taken along A-A in Fig. 1;
Fig. 3 is a sectional view taken along B-B in Fig. 1;
Fig. 4 is a perspective view showing a schematic configuration of parts of the plasma etching apparatus according to the embodiment;
Fig. 5 is an illustration for explaining how the plasma etching apparatus operates according to the embodiment;
Fig. 6 is a front sectional view showing a schematic configuration of a plasma etching apparatus according to another embodiment of the present invention; and
Fig. 7 is a perspective view showing a schematic configuration of parts of a conventional plasma processing apparatus.

### Description of Embodiments

0033 Hereinafter, a specific embodiment of the present invention will be described based on the drawings. Note that the plasma processing apparatus according to the embodiment is a plasma etching apparatus that performs a plasma etching processing on a substrate having a diameter equal to or smaller than 1 inch.

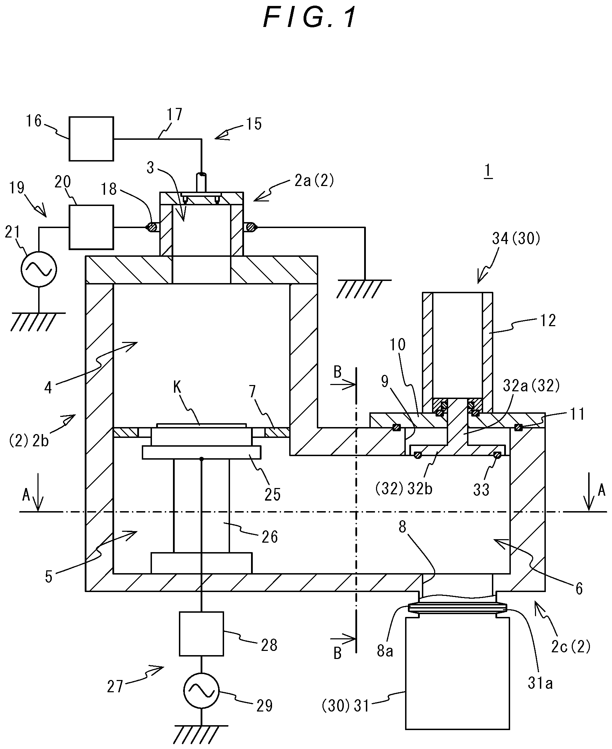

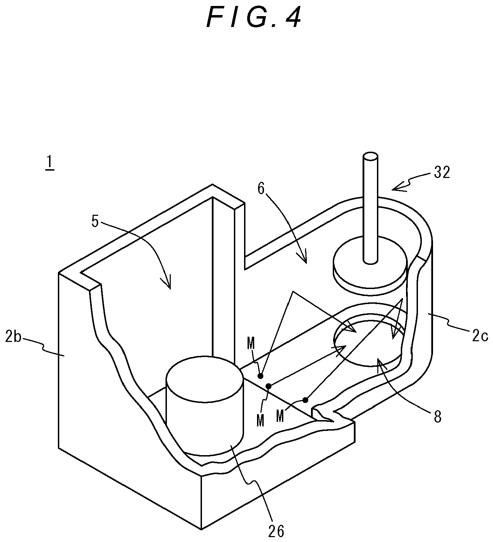

0034 As shown in Figs. 1 to 4, a plasma etching apparatus 1 of this embodiment includes a processing chamber 2 having a plasma generating portion 3, a processing portion 4, an exhaust portion 5, and a manifold portion 6 defined in its inner space, a processing gas supply mechanism 15 for supplying a processing gas into the plasma generating portion 3, a coil 18 disposed outside a portion of the processing chamber 2 where the plasma generating portion 3 is defined, a coil power supply mechanism 19 for supplying RF power to the coil 18, a platen 25 disposed in the processing portion 4 for placing a substrate K thereon, a platen power supply mechanism 27 for supplying RF power to the platen 25, and an exhaust mechanism 30 for exhausting gas in the processing chamber 2 to adjust the pressure in the processing chamber 2 in conjunction with a pressure gauge, which is not shown in the drawings.

0035 The processing chamber 2 is composed of a first chamber 2a, a second chamber 2b connected to the first chamber 2a below the first chamber 2a, and a third chamber 2c connected to the second chamber 2b on a lateral side of the second chamber 2b. The plasma generating portion 3 is defined in the inner space of the first chamber 2a, the processing portion 4, which communicates with the plasma generating portion 3, is defined in an upper region of the inner space of the second chamber 2b, the exhaust portion 5, which communicates with the processing portion 4, is defined in a lower region of the inner space of the second chamber 2b, the manifold portion 6, which communicates with the exhaust portion 5, is defined in the inner space of the third chamber 2c, and these portions communicate with each other from the plasma generating portion 3 to the manifold portion 6.

0036 The first chamber 2a is formed to have an inner diameter of not less than 15 mm and not more than 50 mm, which is appropriate for a substrate K having a diameter equal to or smaller than 1 inch, and the second chamber 2b is formed to have an inner diameter larger than the inner diameter of the first chamber 2a. Further, the second chamber 2b has a dispersion plate 7 attached to an inner wall thereof between the processing portion 4 and the exhaust portion 5; the dispersion plate 7 controls gas flow from the processing portion 4 to the exhaust portion 5.

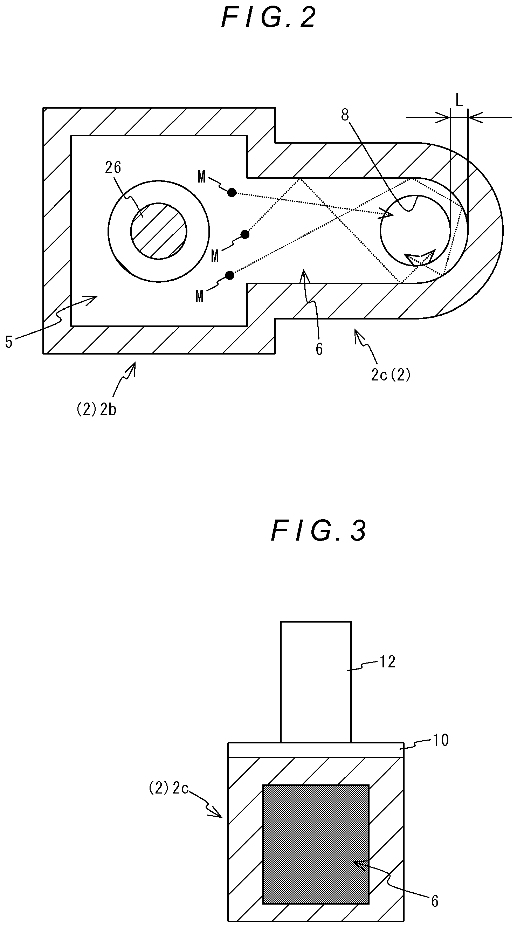

0037 The third chamber 2c is provided to extend in a horizontal direction from a side wall of the second chamber 2b and has a distal end portion having a semicircular shape in top plan view. Further, the third chamber 2c has an opening 8 formed in a lower surface thereof and a flange joint 8a formed at a portion where the opening 8 is formed, and has an opening 9 formed in an upper surface thereof at a position facing the opening 8. Note that the manifold portion 6 has a flow-path effective cross-sectional area, in other words, a cross-sectional area obtained by cutting the manifold portion 6 along a vertical plane perpendicular to the longitudinal direction of the manifold portion 6 (the hatched portion in Fig. 3), larger than the opening area of the opening 8. Further, the opening 8 is formed so that its edge is spaced from an inner wall of the distal end portion of the third chamber 2c by a predetermined distance L, and the width of the distance L is preferably equal to or greater than 20 % of the diameter of the opening 8, more preferably equal to or greater than 25% of the diameter of the opening 8.

0038 Note that, if the manifold portion 6 has, for example, a shape that becomes narrower from the exhaust portion 5 side toward the distal end side (a tapered shape or the like), the flow-path effective cross-sectional area of the manifold portion 6 means the cross-sectional area at the narrowest portion of the manifold portion 6.

0039 The processing gas supply mechanism 15 includes an etching gas supply unit 16 supplying an etching gas, e.g., SF₆ gas, and a supply pipe 17 having one end connected to a plurality of discharge ports provided in the first chamber 2a and the other end connected to the etching gas supply unit 16, and supplies the etching gas into the plasma generating portion 3 from the etching gas supply unit 16 through the supply pipe 17. Note that the etching gas is not limited to SF₆ gas and another fluorine-containing gas, e.g., CF₄, NF₃ or IF₅, can be used as the etching gas.

0040 The coil 18 is disposed outside the first chamber 2a in such a manner that it surrounds the first chamber 2a, and RF power is supplied to the coil 18 by the coil power supply mechanism 19, which is described below.

0041 The coil power supply mechanism 19 is composed of an impedance matching device 20 connected to the coil 18 and an RF power supply unit 21 connected to the impedance matching device 20, and, as described above, the coil power supply mechanism 19 supplies RF power to the coil 18.

0042 The platen 25 is disposed in the processing portion 4 as described above, and is configured to be moved up and down by a lifting cylinder 26.

0043 The platen power supply mechanism 27 is composed of an impedance matching device 28 connected to the platen 25 and an RF power supply unit 29 connected to the impedance matching device 28, and the platen power supply mechanism 27 supplies RF power to the platen 25.

0044 The exhaust mechanism 30 is composed of a vacuum pump 31 having an intake port connected to the opening 8, a valve body 32 inserted through the opening 9, and a moving mechanism 34 for moving the valve body 32 in upward and downward directions; the valve body 32 and the moving mechanism 34 function as an opening and closing mechanism.

0045 The vacuum pump 31 has a flange joint 31 a formed at the intake port, and the flange joint 31 a is connected to the flange joint 8a formed on the third chamber 2c, and thereby the intake port is connected to the opening 8. Note that it is preferred that the vacuum pump is a pump which is directed to high vacuum drawing and examples of the vacuum pump include a turbomolecular pump, a cryo pump, and an oil diffusion pump.

0046 The valve body 32 is composed of a shaft portion 32a and a plate-shaped contact portion 32b provided at a distal end of the shaft portion 32a, and an annular seal member 33 is fixed on a lower surface of the contact portion 32b. The annular seal member 33 has an inner diameter larger than the diameter of the opening 8; when the contact portion 32b is brought close to the opening 8, the annular seal member 33 is brought into contact with the periphery of the opening 8, and thereby airtightness between the third chamber 2c and the contact portion 32 can be maintained. Note that a cover body 10 having a through hole formed therein for inserting the shaft portion 32a of the valve body 32 therethrough is detachably attached at the opening 9 of the third chamber 2c with the valve body 32 inserted through the opening 9, and an annular seal member 11 is interposed between the cover body 10 and the top surface of the third chamber 2c, and thereby airtightness between the cover body 10 and the third chamber 2c is maintained under the condition where the cover body 10 is attached.

0047 The moving mechanism 34 moves the valve body 32 in the upward and downward directions, in other words, along an axial direction of the valve body 32, and the moving mechanism 34 is disposed on the cover body 10 in a state of being supported by a support member 12 fixed on the top surface of the cover body 10. Note that examples of the moving mechanism 34 include a pneumatic cylinder and an electric cylinder.

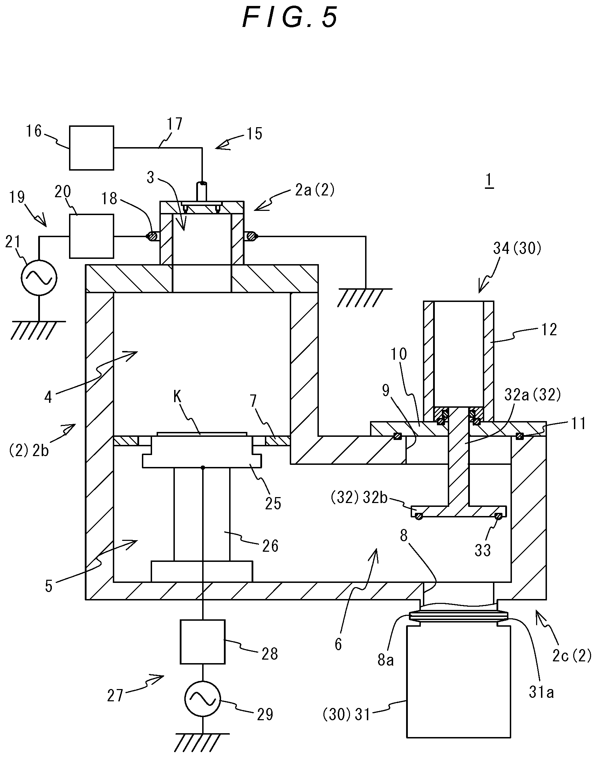

0048 According to this exhaust mechanism 30, gas in the processing chamber 2 (the plasma generating portion 3, the processing portion 4, the exhaust portion 5, and the manifold portion 6) can be exhausted by driving the vacuum pump 31 under the condition where the contact portion 32b of the valve body 32 has been moved to a position spaced from the opening 8 by the moving mechanism 34, and the pressure in the processing chamber 2 can be adjusted by moving the valve body 32 in the upward and downward directions by the moving mechanism 34 and thereby changing the size of the space between the contact portion 32b and the opening 8 to change the exhaust velocity. Fig. 5 shows the valve body 32 in a state of being close to the opening 8.

0049 Note that the valve body 32 and the moving mechanism 34 can be easily detached from the processing chamber 2 by pulling them upward together with the cover body 10.

0050 Next, the process for performing an etching processing on a substrate K (for example, a silicon substrate) using the plasma etching apparatus 1 having the above-described configuration is described.

0051 First, a substrate K having a mask with a predetermined pattern formed on a surface thereof is placed on the platen 25 which is positioned at a lowered position. Subsequently, the platen 25 is moved upward to a processing position by the lifting cylinder 26, and then exhaust of gas in the processing chamber 2 (the plasma generating portion 3, the processing portion 4, the exhaust portion 5, and the manifold portion 6) is started by the exhaust mechanism 30.

0052 By the way, until the processing chamber 2 reaches a low vacuum state after the start of the exhaust of gas in the processing chamber 2, the gas flow corresponds to the viscous flow region in which collision between gas molecules is predominant and the mean free path of gas molecules is short. Therefore, under such a condition, gas molecules reach the intake port of the vacuum pump 31 in such a manner that they are pushed out of the processing chamber 2, and the gas molecules are discharged from the processing chamber 2, by which evacuation of the processing chamber 2 is advanced. However, when the vacuum degree of the processing chamber 2 has been increased, collision of gas molecules with the inner wall of the processing chamber 2 is predominant over collision between gas molecules and the mean free path of gas molecules is long, that is, the gas flow moves from the viscous flow region to the molecular flow region. In the molecular flow region, gas molecules are not discharged from the processing chamber 2 unless gas molecules which freely move at an average speed reach the intake port of the vacuum pump 31; therefore, the evacuation efficiency greatly deteriorates unless the probability that gas molecules reach the intake port of the vacuum pump 31 is increased.

0053 Accordingly, in the plasma etching apparatus 1 of the present embodiment, the manifold portion 6 is formed to have an effective cross-sectional area larger than the opening area of the opening 8. Thereby, conductance of the gas flowing from the manifold portion 6 to the opening 8 is increased in both the viscous flow region and the molecular flow region.

0054 Further, the distance between the inside of the processing chamber 2 and the intake port of the vacuum pump 31 is made as short as possible by connecting the intake port of the vacuum pump 31 to the opening 8 formed in the third chamber 2c with no piping or the like between them so as to increase the probability that gas molecules in the processing chamber 2 reach the intake port of the vacuum pump 31 to thereby increase the evacuation efficiency in the molecular flow region.

0055 Furthermore, the edge of the opening 8 is spaced from the inner wall surface of the distal end portion of the third chamber 2c by the distance L to enlarge the solid angle as viewed from the opening 8, which allows gas molecules M to reach the opening 8 through the distal end side of the third chamber 2c as shown in Fig. 2. Therefore, the probability that gas molecules reach the intake port of the vacuum pump 31 from the inside of the processing chamber 2 is further increased.

0056 Therefore, according to the plasma etching apparatus 1 of the present embodiment, it is possible to efficiently evacuate the processing chamber 2 and rapidly reduce the pressure in the processing chamber 2 to a high vacuum state.

0057 Subsequently, an induced electric field is produced in the plasma generating portion 3 by supplying RF power to the coil 18 from the RF power supply unit 21; under this condition, an etching gas is supplied into the plasma generating portion 3 from the etching gas supply unit 16 and plasma is generated from the supplied etching gas. Note that the RF power supplied to the coil 18 preferably has a frequency equal to or greater than 40 MHz, and further preferably has a power equal to or less than 50 W.

0058 Thereafter, RF power is supplied to the platen 25 from the RF power supply unit 29. Then, the plasma generated from the etching gas in the plasma generating portion 3 flows downward to the processing portion 4 and reaches the substrate K, and thereby the surface of the substrate K is etched and an etching structure is formed in the surface of the substrate K. In the etching processing in the present embodiment, because a bias potential is applied to the substrate K by supplying RF power to the platen 25, ions in the plasma are irradiated onto the substrate K and the so-called ion-assisted etching is performed.

0059 Note that, while the etching processing is being performed on the substrate K, the pressure in the processing chamber 2 is monitored and the exhaust velocity is adjusted by changing the position of the valve body 32 in the upward and downward directions by the moving mechanism 34 so that the pressure in the processing chamber 2 becomes a predetermined pressure (for example, about 3 Pa).

0060 As described above, according to the plasma etching apparatus 1 of the present embodiment, increasing conductance of gas flowing from the manifold portion 6 to the opening 8 prevents the evacuation efficiency in both the viscous flow region and the molecular flow region from deteriorating, and increasing the probability that gas molecules in the processing chamber 2 reach the intake port of the vacuum pump 31 increases the evacuation efficiency especially in the molecular flow region. Therefore, it is possible to rapidly reduce the pressure in the processing chamber 2 to a high vacuum state. Further, it is also possible to control the pressure in the processing chamber 2 in a high vacuum state by adjusting the position of the valve body 32.

0061 Further, since the plasma etching apparatus 1 has the valve body 32 provided in the manifold portion 6 in the third chamber 2c and does not require a connecting member, e.g., a flange joint, which is provided between the manifold portion and the vacuum valve in the conventional art, the apparatus can be made compact and it is possible to create a small-sized plasma etching apparatus that performs an etching processing on a substrate having a diameter equal to or smaller than 1 inch.

0062 Further, in the plasma etching apparatus 1 of the present embodiment, the valve body 32 and the moving mechanism 34 can be easily detached from the processing chamber 2; therefore, maintainability is improved.

0063 One embodiment of the present invention has been described above; however, the present invention is not limited thereto and can be implemented in other modes.

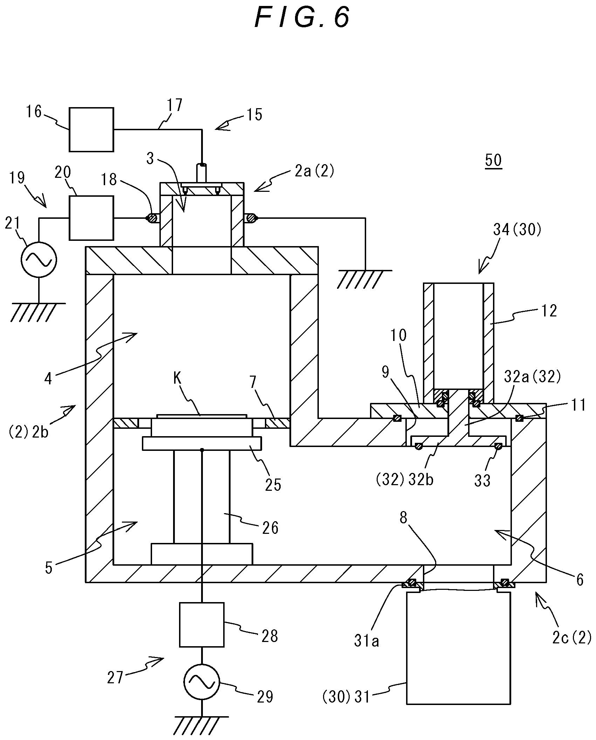

0064 In the above embodiment, the third chamber 2c has the flange joint 8a formed thereon and the intake port and the opening 8 are connected by connecting the flange joint 31 a of the vacuum pump 31 to the flange joint 8a; however, like a plasma etching apparatus 50 shown in Fig. 6, the intake port and the opening 8 may be connected by fixing the flange joint 31 a of the vacuum pump 31 on a lower surface of the third chamber 2c by means of a screw or the like without providing a flange joint on the third chamber 2c.

0065 Further, in the above embodiment, the plasma processing apparatus of the present invention is embodied as a plasma etching apparatus as an example; however, the present invention is not limited thereto and may be embodied as, for example, a plasma CVD apparatus used for forming a thin film on a substrate or a plasma ashing apparatus used for removing a resist.

0066 Furthermore, in the above embodiment, the plasma processing apparatus of the present invention is embodied as a so-called inductively coupled plasma (ICP) etching apparatus 1 having a coil 18; however, the present invention is not limited thereto and may be embodied as a so-called capacitively coupled plasma (CCP) etching apparatus having parallel plate electrodes.

0067 Further, there is no limitation on the substrate K, and examples of the substrate K include substrates made of silicon, silicon carbide, sapphire, compound semiconductor, glass, and resin.

### Reference Signs List

0068
- 1: Plasma etching apparatus
- 2: Processing chamber
- 2a: First chamber
- 2b: Second chamber
- 2c: Third chamber
- 3: Plasma generating portion
- 4: Processing portion
- 5: Exhaust portion
- 6: Manifold portion
- 7: Dispersion plate
- 8: Opening
- 8a: Flange joint
- 10: Cover body
- 15: Processing gas supply mechanism
- 18: Coil
- 19: Coil power supply mechanism
- 25: Platen
- 27: Platen power supply mechanism
- 30: Exhaust mechanism
- 31: Vacuum pump
- 31a: Flange jonit
- 32: Valve body
- 34: Moving mechanism

## Claims

1. A plasma processing apparatus generating plasma from a processing gas supplied into a processing portion defined in a processing chamber and performing a plasma processing on a substrate placed on a platen disposed in the processing portion by the plasma generated from the processing gas, **characterized in that**
the processing chamber has an exhaust portion defined below the processing portion and a manifold portion defined adjacent to the exhaust portion, and has an opening formed in a portion thereof corresponding to the manifold portion, the exhaust portion being a space communicating with the processing portion, the manifold portion being a space communicating with the exhaust portion,
the manifold portion has a flow-path effective cross-sectional area larger than the opening,
the plasma processing apparatus further comprises:
a vacuum pump having an intake port connected to the opening; and
an opening and closing mechanism for opening and closing the opening, and
the opening and closing mechanism is composed of:
a valve body disposed in the manifold portion at a position facing the opening to be movable in approaching and separating directions with respect to the opening; and
a moving mechanism for moving the valve body in the approaching and separating directions.

2. The plasma processing apparatus according to claim 1, **characterized in that** the opening has an edge formed to be spaced from an inner wall of the portion of the processing chamber corresponding to the manifold portion.

3. The plasma processing apparatus according to claim 1, **characterized in that** the opening has an edge formed to be spaced from an inner wall of the portion of the processing chamber corresponding to the manifold portion by a distance equal to or greater than 20 % of a diameter of the opening.

4. The plasma processing apparatus according to claim 1, **characterized in that** the opening has an edge formed to be spaced from an inner wall of the portion of the processing chamber corresponding to the manifold portion by a distance equal to or greater than 25 % of a diameter of the opening.

5. The plasma processing apparatus according to any one of claims 1 to 4, **characterized in that** the intake port of the vacuum pump is directly connected to the opening.

6. The plasma processing apparatus according to any one of claims 1 to 5, **characterized in that** the opening and closing mechanism can be attached to and detached from the processing chamber along the approaching and separating directions.

7. An opening and closing mechanism used in a plasma processing apparatus including a processing chamber having a processing portion defined in its inner space, the processing portion being to be supplied with a processing gas and having a platen disposed therein for placing thereon a substrate to be processed by plasma generated from the processing gas,
the processing chamber having an exhaust portion defined below the processing portion and a manifold portion defined adjacent to the exhaust portion, and having an opening formed in a portion thereof corresponding to the manifold portion, the exhaust portion being a space communicating with the processing portion, the manifold portion being a space communicating with the exhaust portion,
the manifold portion having a flow-path effective cross-sectional area larger than the opening,
the plasma processing apparatus further including a vacuum pump having an intake port, the intake port being connected to the opening open to a lower surface of the portion of the processing chamber corresponding to the manifold portion,
the opening and closing mechanism **characterized by** being composed of:
a valve body disposed in the manifold portion at a position facing the opening to be movable in approaching and separating directions with respect to the opening; and
a moving mechanism for moving the valve body in the approaching and separating directions.

8. The opening and closing mechanism according to claim 7, **characterized in that** the opening has an edge formed to be spaced from an inner wall of the portion of the processing chamber corresponding to the manifold portion.

9. The opening and closing mechanism according to claim 7, **characterized in that** the opening has an edge formed to be spaced from an inner wall of the portion of the processing chamber corresponding to the manifold portion by a distance equal to or greater than 20 % of a diameter of the opening.

10. The opening and closing mechanism according to claim 7, **characterized in that** the opening has an edge formed to be spaced from an inner wall of the portion of the processing chamber corresponding to the manifold portion by a distance equal to or greater than 25 % of a diameter of the opening.

11. The opening and closing mechanism according to any one of claims 7 to 10, **characterized in that** the intake port of the vacuum pump is directly connected to the opening.

12. The opening and closing mechanism according to any one of claims 7 to 11, **characterized in that** it can be attached to and detached from the processing chamber along the approaching and separating directions.
